# EUROPEAN PATENT SPECIFICATION

(11) **EP 3 123 524 B1**
(45) Date of publication and mention of the grant of the patent: **12.02.2020**
(21) Application number: 15713802.5
(22) Date of filing: 27.03.2015
(51) Int. Cl.: H01L 31/0352, H01L 31/047

(54) **OPTOELECTRONIC DEVICE AND METHOD OF PRODUCING THE SAME**
OPTOELEKTRONISCHE VORRICHTUNG UND VERFAHREN ZUR HERSTELLUNG DAVON
DISPOSITIF OPTOÉLECTRONIQUE ET SON PROCÉDÉ DE FABRICATION

(30) Priority: 28.03.2014 GB 201405662
(43) Date of publication of application: 01.02.2017
(73) Proprietor: Power Roll Limited, Sunderland Tyne and Wear SR5 3NZ (GB)
(72) Inventor: TOPPING, Alexander John, Abingdon Oxfordshire OX14 4BS (GB)
(74) Representative: HGF Limited
(86) International application number: PCT/GB2015/050925
(87) International publication number: WO 2015/145166

(56) References cited:
- EP-A2- 2 282 352
- JP-A- 2009 246 041
- US-A- 4 376 872
- US-A1- 2010 244 056
- US-A1- 2013 160 818

## Description

The present invention relates to an optoelectronic device and more specifically a solar photovoltaic cell.

The term photovoltaic refers to the production of electricity, normally direct electrical current, from light at the junction between two materials that are exposed to the light. The light is normally sunlight and therefore photovoltaic is often referred to as solar photovoltaic. It is known to use semiconductors for the two materials. The semiconductor materials used exhibit a photovoltaic effect.

The two materials are usually semiconductors, a p-type and an n-type semiconductor material. When joined together the boundary or interface between the two types of semiconductor material is referred to as a p-n junction. This type of p-n junction is usually created by doping one material with the other material. The doping may be by diffusion, ion implantation or epitaxy. The later involves growing a second layer of crystal doped with one type of dopant on top of a first layer of crystal doped with a different type of dopant.

The p-n junction can be found in most optoelectronic devices that use semiconductors. These optoelectronic devices include photovoltaic or solar photovoltaic cells, diodes, light-emitting diodes (LEDs) and transistors. The p-n junction can be thought of as the active site where the generation or consumption of electrical energy occurs.

The demand for sources of renewable energy has driven significant improvements in the cost and efficiency of solar photovoltaic cells but existing technology still represents a relatively expensive method of generating electricity. Also, existing solar photovoltaic cells are relatively inefficient compared to other methods of generating electricity and are relatively fragile, that is they are relatively easily damaged.

One of the problems with existing solar photovoltaic cells is the difficulty in extracting and/or collecting electrical charge from the solar photovoltaic cell. The present invention aims to mitigate one or more of the disadvantages of existing solar photovoltaic cells.

US2013/0160818 describes a solar cell system including a substrate, a number of solar cells and a number of reflectors.

JP2009246041 describes a solar battery comprising a glass substrate on which the solar battery cells include a photelectric conversion element having a PN junction and a wire connected with a first transparent electrode of the element.

The invention is in accordance with the appended claims.

In accordance with a first aspect of the present invention there is provided an optoelectronic device comprising:
a substrate having a first and a second substantially planar face;
a series of grooves in the first substantially planar face, the series of grooves including a first outermost groove and a second outermost groove; and
a first and a second aperture in the substrate;
wherein the first aperture provides electrical communication between the first outermost groove and the second substantially planar face of the substrate and the second aperture provides separate electrical communication between the second outermost groove and the second substantially planar face of the substrate; wherein the second
substantially planar face of the substrate further comprises a first and a second electrical conductor, the first and second electrical conductors being electrically insulated from one another, thereby helping to provide the separate electrical communication between the second outermost groove and the second substantially planar face of the substrate; and wherein each groove of the series of grooves has a first and a second face and a cavity therebetween, the cavity at least partially filled with a first semiconductor material, the first face coated with a conductor material and the second face coated with a second semiconductor material;
wherein sides of the first and second apertures are coated with one or more of the conductor material, the first semiconductor material and the second semiconductor material.

In use, the first and second apertures are used to carry electrical charge between the first and the second substantially planar faces of the substrate, and typically from the first to the second substantially planar face of the substrate.

The first aperture typically passes through the first substantially planar face of the substrate proximate to the first outermost groove and through the first electrical conductor on the second substantially planar face of the substrate. The second aperture typically passes through the first substantially planar face of the substrate proximate to the second outermost groove and through the second electrical conductor on the second substantially planar face of the substrate.

The first and second electrical conductors may provide and/or be part of the positive and negative poles of an electrical circuit. The first and second electrical conductors may comprise one or more of aluminium, copper, silver, zinc, lead, antimony, gold, nickel, bismuth, and indium.

It may be an advantage of the present invention that in use, the first and second electrical conductors are used to collect from and/or convey an electrical charge along a length of the optoelectronic device, these electrical conductors having a lower electrical resistance compared to the first substantially planar face and/or the series of grooves. This typically means that the length of the optoelectronic device and hence the number of grooves and/or number of series of grooves can be increased without an otherwise corresponding decrease in the electrical charge that can be collected.

The first and second apertures may be two of the plurality of apertures. The plurality of apertures may comprise a first group of apertures including the first aperture and a second group of apertures including the second aperture. The apertures of the first group of apertures may all pass through and/or be in electrical communication with the first electrical conductor. The apertures of the second group of apertures may all pass through and/or be in electrical communication with the second electrical conductor.

The first and second apertures may have a diameter of from 0.5 to 2000 microns, typically from 10 to 50 microns. There may be at least one aperture for every from 3 to 10cm² of the substrate, typically at least one aperture for every 5cm² of the substrate. It may be an advantage of the present invention that the number of apertures in the substrate is such that the substrate is not structurally weakened. The substrate is typically flexible.

The apertures of the first group of apertures may be connected in parallel to the first electrical conductor. The apertures of the second group of apertures may be connected in parallel to the second electrical conductor.

The first and second electrical conductors may be referred to as first and second bus bars. The first and second electrical conductors may be referred to as first and second collecting strips.

The first and second apertures may holes and/or slots. The first and second holes may have a circular cross-section. The first and second holes may be square and/or have a square cross-section. The first and second slot may be elongate in one dimension. The first and second slot may be elongate in the x-axis or y-axis.

The first and second apertures in the substrate typically have the same shape and/or design. The first and second apertures may be described as passing through the substrate.

The first and second apertures may be at least partially, typically substantially filled with a filler material. The filler material is typically an electrical conductor. The electrical conductor may be an ink. The ink may be a conductive ink. The filler material, typically the ink, may be substantially organic or substantially inorganic. The filler material, typically the ink, may comprise an organic binder. The filler material, typically the ink, may comprise one or more of carbon, silver, copper and lead.

In use, the electrical communication may include the transfer of an electrical charge. The electrical charge typically includes an electrical current.

The series of grooves may comprise a first and a second series of grooves. The substrate may further comprise a channel between the first and second series of grooves.

Each groove of the series of grooves or the first and second series of grooves has a first and a second face and a cavity therebetween. The cavity is normally at least partially filled with a first semiconductor material. The first face is normally coated with a conductor material and the second face coated with a second semiconductor material. The channel typically also transects the grooves of the first and second series of grooves.

The side or sides of the first and second apertures are normally coated with the conductor material and/or the semiconductor material. The aspect ratio of the depth to the width of the first and second apertures is typically such that the conductor material and/or the semiconductor material coats enough of the side or sides of the first and second apertures to establish the electrical communication between the first and second outermost grooves and the second substantially planar face of the substrate.

The first and second apertures may be at least partially filled with the filler material to increase the reliability and/or effectiveness of the electrical communication between the first and second outermost grooves and the second substantially planar face of the substrate.

The first and second apertures may have been formed by an elongate member being pushed through the substrate from the first and/or second substantially planar face. The elongate member may remain in the substrate during use. The elongate member may provide the electrical communication between the first or second outermost groove and the second substantially planar face of the substrate.

The elongate member may be a pin or a nail. The elongate member may be sized such that when it is in the aperture, the elongate member is in contact with the conductor material and/or the semiconductor material on the sides of the aperture. Contact between the elongate member and the conductor material and/or the semiconductor material on the sides of the aperture typically helps provide the electrical communication between the first and second outermost grooves and the second substantially planar face of the substrate.

The side or sides of the first and second apertures extending between, and in electrical communication with, the first and second substantially planar faces of the substrate are coated with one or more of the conductor material, the first semiconductor material and the second semiconductor material. It is typically one or more of the conductor material, the first semiconductor material and the second semiconductor material that provides the electrical communication between the first outermost groove and the second substantially planar face of the substrate and the second outermost groove and separately the second substantially planar face of the substrate.

When the first and second apertures are at least partially filled with the filler material, it may be the filler material that provides the electrical communication between the first outermost groove and the second substantially planar face of the substrate and the second outermost groove and the second substantially planar face of the substrate. When the side or sides of the first and second apertures extending between, and in electrical communication with, the first and second substantially planar faces of the substrate are coated with one or more of the conductor material, the first semiconductor material and the second semiconductor material and the first and second apertures are at least partially filled with the filler material, it may be one or more of the conductor material, the first semiconductor material and the second semiconductor material and the filler material that provides the electrical communication between the first outermost groove and the second substantially planar face of the substrate and the second outermost groove and the second substantially planar face of the substrate.

The channel typically separates the first and second series of grooves such that an electrical current can be taken from or supplied to the first series of grooves in isolation from the second series of grooves.

The first and second series of grooves are typically elongate grooves. The channel between the first and second series of grooves is typically an elongate channel.

The channel typically transects the grooves of the first and second series of grooves at or towards an end of each groove. The channel typically transects or crosses the grooves of the first series of grooves towards an end of each groove and then passes between the first and second series of grooves before transecting or crossing the grooves of the second series of grooves towards an opposite and/or opposing end of each groove.

The first and second faces of each of the grooves of the first and second series of grooves may be coated with the conductor material. The first and second faces of each of the grooves of the first and second series of grooves may be coated with the second semiconductor material.

The second face may be coated with the second semiconductor material and the first face coated with a third semiconductor material. The first semiconductor material at least partially filling the cavity may be an intrinsic semiconductor.

The first and second faces of each of the grooves of the first and second series of grooves may be referred to as the integral first and integral second faces respectively. The integral first face is normally at a first angle relative to a normal from the substrate and the integral second face at a second angle relative to a normal from the substrate.

The first angle is normally from 45 to less than 90°. The second angle is normally from 45 to less than 90°.

The first semiconductor material is typically a p-type semiconductor material. The second semiconductor material is typically an n-type semiconductor material. The p-type semiconductor is therefore normally in the cavity of the grooves.

In an alternative example the first semiconductor material is an n-type semiconductor material and the second semiconductor material is a p-type semiconductor material.

The n-type and p-type semiconductors may comprise one or more of silicon, amorphous silicon, hydrogenated amorphous silicon, aluminium, germanium, gallium nitride, gallium arsenide, aluminium phosphide, aluminium arsenide, copper iodide, zinc oxide and any other semiconductor.

The n-type semiconductor typically comprises one or more of silicon, germanium, phosphorus, selenium, tellurium, cadmium sulphide, Copper Zinc Tin Sulfide (CZTS), Quantum Dot (QD) materials for example lead sulphide and organic materials for example perovskites.

The p-type semiconductor typically comprises one or more of silicon, germanium, cadmium telluride, copper indium gallium selenide, lead sulphide, cadmium telluride, copper indium gallium diselenide ('CIGS'), copper oxide, boron, beryllium, zinc, cadmium, Copper Zinc Tin Sulfide (CZTS), Quantum Dot (QD) materials for example lead sulphide and organic materials for example perovskites.

The first and second semiconductor materials may meet at an interface and/or boundary. The interface is typically referred to as a p-n junction. The first and second semiconductor materials may together be referred to as an active material.

The active material may be deposited in the cavity and on the first and/or second face of the cavity and may provide ohmic and rectifying contacts for insertion or extraction of charge from the active material. The active material may be one or more of photovoltaic, light emitting and ion conducting.
The second face may be coated with a conductor material and the second semiconductor material. The conductor material coated on the first face may be the same as the conductor material coated on the second face but it may be different. The conductor material coated on the first and/or second face may comprise one or more of aluminium, bismuth, cadmium, chromium, copper, gallium, gold, indium, lead, magnesium, manganese, samarium, scandium, silver, tin and zinc.

The second semiconductor material may be an electron blocking material such as molybdenum trioxide. The first semiconductor material may be a heterojunction, that is a mixture of one or more of a p-type semiconductor, n-type semiconductor and donor acceptor material.

Typically a portion, normally a substantial portion, of the first and second series of grooves and channel therebetween are substantially parallel, typically parallel to one another. The channel may extend across the first and second series of grooves and typically across the end of the first and second series of grooves. The channel may extend across the first and second series of grooves and typically across opposing ends of the first and second series of grooves.

In an alternative example a portion, normally a substantial portion, of the first and second series of grooves and channel therebetween may be offset from one another, that is not parallel to one another.

The channel may extend both perpendicular to and parallel to the first and second series of grooves. Normally the channel is perpendicular to the first and second series of grooves when it extends across the ends of the first and second series of grooves. Normally the channel is parallel to the first and second series of grooves when it extends between the first and second series of grooves. The angle at which the channel may extend across the ends of the first and second series of grooves can be variable and optionally be from 0 to 90°, normally from 35 to 55° and typically be 45°.

When the channel extends both perpendicular to and parallel to the first and second series of grooves, the channel may be referred to as running in at least two directions to connect said first and second series of grooves. When the channel extends substantially perpendicular and across the ends of the first and second series of grooves, it may also extend in at least two directions relative to the first and second series of grooves. When the channel extends in at least two directions relative to the first and second series of grooves it typically forms a zigzag shape.

A surface of the substrate comprising the first and second series of grooves and a channel therebetween may be referred to as a structured surface. The structured surface is typically not flat. The substrate may have another surface that is flat.

The channel may be referred to as a delineation feature. The channel typically separates the first and second series of grooves. The channel typically has a first and a second face and a channel cavity therebetween. At least the first face of the channel may be coated with the conductor material and the second face of the channel may be coated with the second semiconductor material. The second face of the channel may also be coated with the conductor material. The channel cavity between the first and second faces of the channel is normally at least partially filled with the first semiconductor material.

The channel typically has a first face at a first angle relative to a normal from the substrate and a second face at a second angle relative to a normal from the substrate. The first face of the channel and the second face of the channel may be perpendicular to the plane of the substrate. The first angle is normally from 45 to less than 90°. The second angle is normally from 45 to less than 90°.

The first semiconductor material in the cavity, second semiconductor material on the second face and conductor material on at least the first face of each groove of the first and second series of grooves are normally all in electrical communication. The electrical communication is such that normally an electrical current can flow between the first and second semiconductor materials and the conductor material.

There is usually no electrical communication between the first semiconductor material in the channel cavity, second semiconductor material on the second face and conductor material on at least the first face of the channel.

The depth of the first semiconductor material in the cavity between the first and second faces of each of the first and second series of grooves is substantially the same or at least similar to the depth of the first semiconductor material in the channel cavity between the first and second faces of the channel.

A first side and a second side of the channel may provide the positive and negative poles of an electrical circuit. The first and second sides may be in electrical communication with the conductor material on the first and second faces of the channel. The first side of the channel may be in electrical communication, typically attached to, the positive pole of the electrical circuit. The second side of the channel may be in electrical communication, typically attached to, the negative pole of the electrical circuit.

Electricity in the electrical circuit may have one or more of a current of from 1 milliamp to 1 amp, a potential of from 0.1 to 3 volts and a power of from 1x10⁻⁶ to 3 watts.

The first and second sides of the channel may be adjacent to the channel. The first and second sides of the channel may be at least substantially parallel to the plane of the substrate.

The channel is typically non-conductive. The channel typically separates and/or insulates the first and second sides of the channel from one another.

The optoelectronic device may be referred to as a two terminal device. The first and second series of grooves may be referred to as cascaded groove structures. In use the device may be fabricated in a series arrangement and operated in a parallel or a combined series and parallel arrangement.

The cavity between the first and second faces of the first and second series of grooves may be any shape and is normally U-shaped, V-shaped or semi-spherical. The cavity between the first and second faces of the first and second series of grooves may have a flat bottom. The channel cavity between the first and second faces of the channel may be any shape and is normally U-shaped, V-shaped or semi-spherical. The channel cavity between the first and second faces of the channel may have a flat bottom. The shape of the cavity between the first and second faces of the first and second series of grooves may be the same or different to the shape of the channel cavity between the first and second faces of the channel.

The bottom of the channel cavity may be flat or may be rutted. The rutted bottom of the channel cavity may be referred to as uneven or rough. The rutted bottom of the channel cavity typically increases the surface area of the bottom of the channel cavity. Increasing the surface area of the bottom of the channel cavity may help to ensure the channel separates and/or insulates the first and second sides of the channel from one another.

The channel and grooves of the first and second series of grooves typically have a depth measured from an upper surface of the substrate to a point in the channel or groove furthest from the upper surface.

The depth of the channel is typically greater than the depth of the grooves of the first and second series of grooves. The depth of the channel may be at least twice the depth of the grooves of the first and second series of grooves.

The channel has a depth and a width. The depth of the channel is typically twice the width of the channel. The aspect ratio for the depth to the width of the channel is therefore typically 2:1.

The first and second series of grooves typically form a series of ridges and cavities. The first and second series of grooves may comprise from 2 to 500 cavities.

The inventor of the present invention has appreciated that, in contrast to the usual trend towards reducing the cost and increasing the efficiency of optoelectronic devices, if the costs are significantly reduced, may be by up to an order of magnitude, then the efficiency may be less important. When the optoelectronic device is a solar photovoltaic cell, this is particularly useful if the durability of the solar photovoltaic cells can be improved so that installation is relatively easy and therefore low cost and the solar photovoltaic cells have a greater range of application.

The optoelectronic device according to the present invention may be one or more of attached, secured and applied to a vehicle, for example a car or lorry, a house, for example a roof, and any other surface of a permanent structure. The permanent structure may be man-made or natural.

A surface that the optoelectronic device is one or more of attached, secured and applied to may be flat or uneven, that is one or more of rough, bumpy, irregular and/or rutted. The surface may be part of a building including a house and/or a domestic roof Each of the grooves of the first and second series of grooves is typically from 5 to 200mm long, normally from 5 to 1000mm long. Each of the grooves of the first and second series of grooves is typically from 0.1 to 100µm wide, normally from 0.3 to 5µm wide.

The substrate may comprise a curable resin and in particular a UV curable resin. The substrate may comprise one or more of an acrylic resin coated onto polyvinyl chloride (PVC), acrylic resin coated onto polyethylene terephthalate (PET), acrylic resin coated onto polyethylene naphthalate (PEN), a biopolymer coated onto polyvinyl chloride (PVC), a biopolymer coated onto polyethylene terephthalate (PET) and a biopolymer coated onto polyethylene naphthalate (PEN).

The first and second series of cascaded groove structures may comprise the substrate. In accordance with a second aspect of the present invention there is provided a method of producing an optoelectronic device, the method including the steps of:
providing a substrate comprising a first and a second substantially planar face, the second substantially planar face comprising a first and a second electrical conductor, the first and second electrical conductors being electrically insulated from one another;providing a first and a second aperture in the substrate, and a series of grooves in the first substantially planar face, the series of grooves including a first outermost groove and a second outermost groove, each groove of the series of grooves having a first and a second face and a cavity therebetween;
coating at least the first face with a conductor material and coating the second face with a semiconductor material; and
   at least partially filling the cavity with another semiconductor material, wherein the step of coating at least the first face with the conductor material and coating the second face with the semiconductor material or the step of at least partially filling the cavity with the another semiconductor material, also at least partially coats a side or sides of the first or second aperture or fills the first or second aperture with one or more of the conductor material, the semiconductor material and the another semiconductor material.

The method may separately include the step of creating the first and the second aperture in the substrate. The step of creating the first and the second aperture in the substrate may be before or after the step of coating at least the first face with the conductor material and coating the second face with the semiconductor material and/or the step of at least partially filling the cavity with the another semiconductor material.

It may be an advantage that when the substrate is provided with the first and second aperture therein, and/or the method separately includes the step of creating the first and the second aperture in the substrate before the coating and filling steps, and then the first and/or second aperture is at least partially filled with one or more of the conductor material, the semiconductor material and the another semiconductor material, these materials provide the first and/or second aperture and/or substrate surrounding the first and/or second aperture with additional structural strength.

The first aperture typically provides electrical communication between the first outermost groove and the second substantially planar face of the substrate and the second aperture provides separate electrical communication between the second outermost groove and the second substantially planar face of the substrate.

The substrate typically also comprises a channel between the first and second series of grooves. The channel typically also transects the grooves of the first and second series of grooves.

The semiconductor material coated on the second face of each groove may be referred to as a second semiconductor material. The another semiconductor material at least partially filling the cavity may be referred to as a first semiconductor material.

The step of coating the at least first face of each groove with the conductor material and coating the second face of each groove with the semiconductor material is normally before the step of at least partially filling the cavity with the another semiconductor material.

The channel typically has a first and a second face and a channel cavity therebetween.

The step of at least partially filling the cavity between the first and second faces of the grooves with the another semiconductor material also typically at least partially fills the channel cavity with the another semiconductor material.

The first and second semiconductor materials are typically different. The first semiconductor material is typically a p-type semiconductor material. The second semiconductor material is typically an n-type semiconductor material.

The step of coating at least the first face of each groove of the first and second series of grooves with the conductor material and coating the second face of each groove of the first and second series of grooves with the semiconductor material typically comprises an off-axis directional coating process. The step of at least partially filling the cavity of each groove with the another semiconductor material typically comprises one or more of an off-axis directional coating process, directional coating process and uniform coating process.

The first and second faces and cavity of each groove of the first and second series of grooves are normally configured to be coated by an off-axis directional coating process.

The method step of coating at least the first face of each groove of the first and second series of grooves with the conductor material is typically before the step of coating the second face of each groove of the first and second series of grooves with the semiconductor material. The method step of at least partially filling the cavity with the another semiconductor material typically follows these coating steps.

The off-axis directional coating process may include spraying the conductor material and/or the semiconductor material at an angle relative to the plane of the substrate, and therefore also each of the grooves of the first and second series of grooves, such that only the first or second face of each groove of the first and second series of grooves is coated. This is typically because the coating is substantially restricted by viewing angle of the coating process to only one of the first or second face.

The off-axis directional coating is typically performed in a partial vacuum. The partial vacuum normally ensures the coating material, typically a vapour, has a mean free path from a source to the substrate, that is a direct and un-diverted path free from interactions with gas molecules. The coating material may be the conductor material, the semiconductor material or the another semiconductor material.

Generally the mean free path of travel of atomised coating material is comparable to the distance between the source and the surface of the substrate to be coated. Off-axis directional coating in a partial vacuum, also referred to as vacuum evaporation coating, at pressures below 10⁻⁴ mbar is typically directional due to the mean free path being approximately 600mm. The source can be angled to the first or second substantially planar face of the substrate so that a restricted view of the surface of the substrate is presented and this restricted view allows for coating on selective parts of the substrate by a process of self-shadowing. The mean free path may also be defined as the length of a path an atom or molecule can travel before it is expected to have interacted with another atom or molecule. At atmospheric pressure the mean free path is typically 67nm. Calculated using nitrogen as the total atmosphere and a partial vacuum level of 0.0001mbar, the mean free path is typically 66cm. At a partial vacuum of 0.00001mbar, the mean free path increases to 6.6 meters.

The conductor material, the semiconductor material and/or the another semiconductor material may be sprayed onto and/or towards the substrate at an angle relative to the plane of the substrate of from 25 to 90°, normally from 35 to 55°, and typically 45°. When the conductor material, the semiconductor material and/or the another semiconductor material is sprayed onto the substrate at an angle relative to the plane of the substrate of from 25 to 90°, normally from 35 to 55° and typically 45°, coating the side or sides of the first and second apertures with the conductor material, the semiconductor material and/or the another semiconductor material coats the side or sides at least 25%, normally more than 50% of the length of the first and/or second apertures away from the surface of the substrate nearest the source.

It may be an advantage that coating the side or sides of the first and second apertures with the conductor material, the semiconductor material and/or the another semiconductor material at least 25%, normally more than 50% of the length of the apertures away from the surface of the substrate nearest the source helps to provide adequate, typically good electrical conduction from the first to the second substantially planar face of the substrate, and/or from the second to the first substantially planar face.

The angle at which conductor material, the semiconductor material and/or the another semiconductor material is sprayed onto and/or towards the first substantially planar face of the substrate, may be the same, typically different from the angle at which conductor material, the semiconductor material and/or the another semiconductor material is sprayed onto and/or towards the second substantially planar face of the substrate.

The aperture may be a hole and/or a slot. It may be an advantage of the present invention that when the aperture is a slot, the aspect ratio for the depth to the width of the slot may improve the viewing angle of the coating process for at least one, normally at least two, of the sides of the slot.

The off-axis directional coating process may include using a shield to restrict the coating of the conductor material and/or the semiconductor material onto the at least first and/or second face of each groove of the first and second series of grooves. The off-axis directional coating process may be repeated using more than one conductor material and/or semiconductor material.

The step of providing the substrate typically includes patterning a surface of the substrate to produce a structured surface.

The optional features of the first aspect of the present invention can be incorporated into the second aspect of the present invention and vice versa.

An embodiment of the invention will now be described by way of example only and with reference to the accompanying drawings, in which:
Figure 1a is a plan view of an optoelectronic device of the present invention;
Figure 1b is a plan view of an alternative optoelectronic device of the present invention;
Figure 2a is a cross-sectional view of part of the optoelectronic device shown in Figures 1a and 3a;
Figure 2b is a cross-sectional view of part of the alternative optoelectronic device shown in Figures 1a and 3a;
Figure 3a is a plan view of a reverse or second side of the optoelectronic device shown in Figure 1a; and
Figure 3b is a plan view of a reverse or second side of the optoelectronic device shown in Figure 1b.

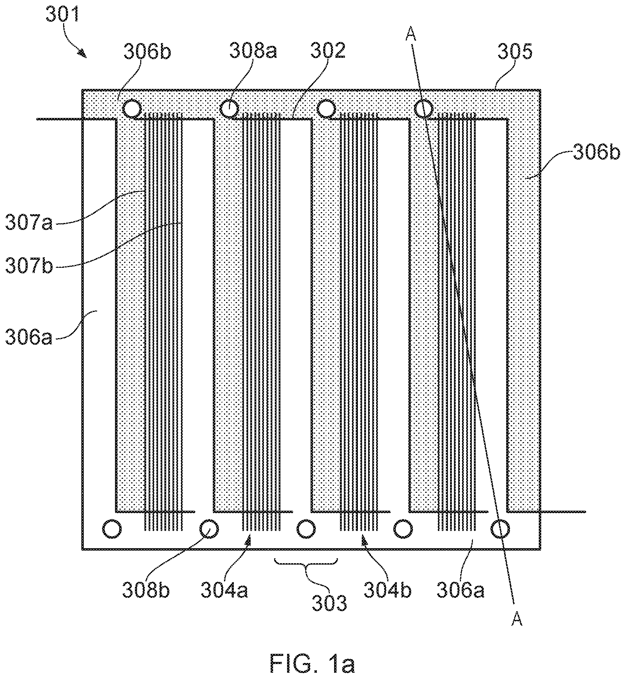

Figure 1a shows a plan view of the optoelectronic device 301 comprising a substrate 305. Only the first substantially planar face of the substrate is shown in Figure 1a. The substrate 305 has a surface comprising a first 304a and a second 304b series of grooves and a channel 302 therebetween. Figure 1a also shows a first outermost groove 307a and a second outermost groove 307b of the first series of grooves 304a and a first 308a and a second 308b aperture in the substrate 305.

The optoelectronic device 301 is a solar photovoltaic cell. The optoelectronic device 301 includes a mixture of interdigitated (parallel connected) and cascaded (series connected) grooves 304. The operating voltage of the optoelectronic device 301 can be controlled by changing the number of series of grooves 304a & 304b. Increasing the number of series of grooves 304a & 304b increases the operating voltage of the optoelectronic device 301. The optoelectronic device 301 can be operated in parallel or a combination of series and parallel arrangement. It may be an advantage of the optoelectronic device 301 that this removes the need for extra process steps to be used to connect the cascaded groove structures in series to achieve the desired output voltage.

The channel 302 is a means to separate but also connect the cascaded (series connected) grooves 304a & 304b in parallel, in order to make it possible to extract the desired electric charge generated at the voltage designed by the number of cascaded groove structures 304a & 304b.

The channel 302, also referred to as the delineation or structural delineation feature first crosses the first series 304a of cascaded grooves towards the edge of the structured web and then crosses a space 303 between the cascaded grooves 304a & 304b, and subsequently crosses the second series of cascaded grooves 304b towards the opposite edge of the structured web. Since many of these structural delineation features 302 are used, each series of cascaded grooves, 304a & 304b for example, are crossed towards each edge by elements of two successive individual delineation features 302, as depicted in Figure 1a.

The spaces 303 are divided into first 306a and second 306b areas. The first area 306a carries a positive charge and the second area 306b carries a negative charge 306b.

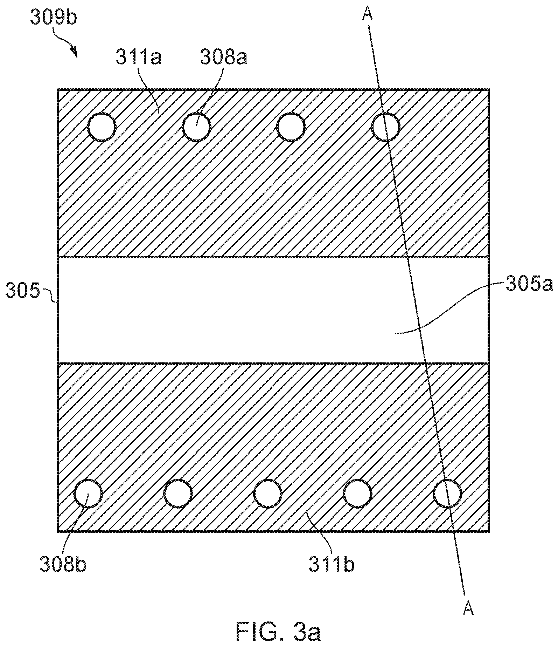

The first aperture 308a provides electrical communication between the first outermost groove 307a and the second substantially planar face of the substrate (as shown in Figure 3a). The second aperture 308b provides separate electrical communication between the second outermost groove 307b and the second substantially planar face of the substrate (as shown in Figure 3a).

A first group of apertures including the first aperture 308a is shown at the top of Figure 1a and a second group of apertures including the second aperture 308b is shown at the bottom of Figure 1a. The group of apertures are shown horizontally spaced in Figure 1a.

The first aperture 308a passes through the first substantially planar face (shown in Figure 1a) of the substrate 305 proximate to the first outermost groove 307a and through the first electrical conductor on the second substantially planar face of the substrate (as shown in Figure 3a). The second aperture 308b passes through the first substantially planar face (shown in Figure 1a) of the substrate 305 proximate to the second outermost groove 307b and through the second electrical conductor on the second substantially planar face of the substrate (as shown in Figure 3a).

It may be an advantage that the optoelectronic device of the present invention does not suffer from the same sensitivity to defects in its structure compared to other known optoelectronic devices of the prior art. Any defect in the structure of a typical known planar sandwich construction solar photovoltaic cell for example will severely affect the overall performance of the cell into which the sandwich construction is incorporated. This means the fabrication processes must be kept very clean and any subsequent coating process must be highly uniform. These requirements reduce the process yields and throughputs as materials deposited in the sandwich construction must be very uniform and this requires the processing to be carefully controlled.

Furthermore, the typical known planar sandwich construction has a transparent conducting layer, which may be, for example, zinc oxide or indium oxide based, which is expensive. Also, any error made during the subsequent manufacturing processes to produce the desired voltage from the sandwich construction are therefore costly. The transparent conducting layer requires a high temperature for its deposition in order to achieve the required performance for commercial products, further increasing the cost of fabrication of the device.

The optoelectronic device of the present invention may mitigate some or all of the above disadvantages of known solar photovoltaic cells having a planar sandwich construction. The channel or delineation feature 302 is created with the grooves 304, before coating. Some known systems first produce the grooves, then coat the grooves before producing the delineation feature 302.

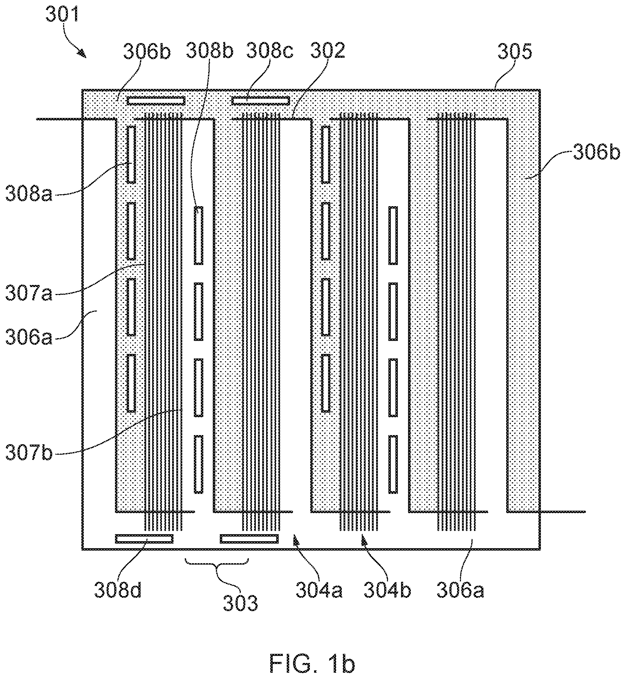

Figure 1b shows a plan view of an alternative optoelectronic device 301 comprising a substrate 305. Only the first substantially planar face of the substrate is shown in Figure 1a. The substrate 305 has a surface comprising a first 304a and a second 304b series of grooves and a channel 302 therebetween. Figure 1b also shows a first outermost groove 307a and a second outermost groove 307b of the first series of grooves 304a. Figure 1b shows a first 308a and a second 308b aperture in the substrate 305. Alternatively, apertures 308c and 308d may be referred to as the first and second apertures respectively.

Other features of the optoelectronic device 301 shown in Figure 1b are the same as those shown in Figure 1a.

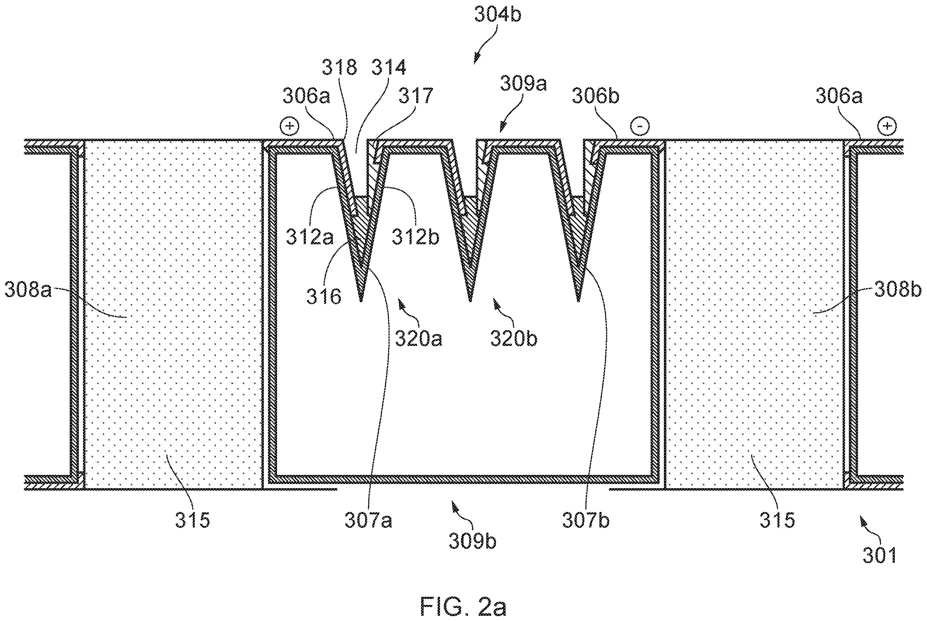

Figure 2a shows a cross-sectional view of part of the optoelectronic device 301 shown in Figures 1a and 3a along the line A-A. Each groove 320a & 320b for example, of a series of grooves 304b has a first face 312a and a second face 312b and a cavity 314 therebetween.

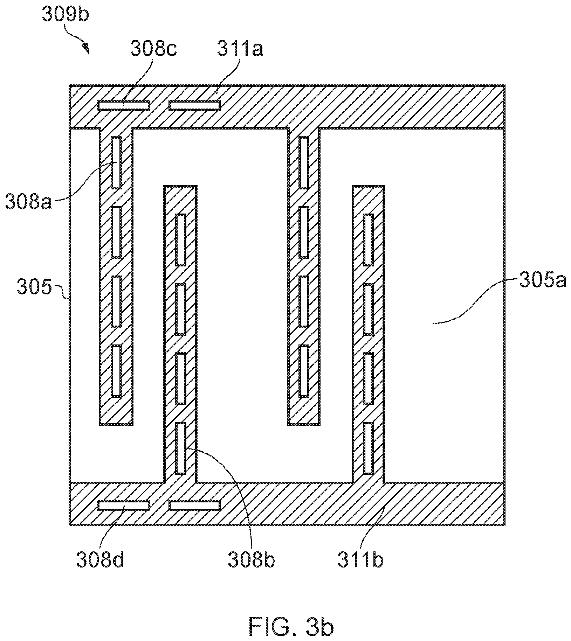

Figure 2a shows the apertures 308a and 308b filled with filler material 315. Figure 2a shows the first substantially planar face 309a of the substrate 305 (as shown in Figure 1b) and the second substantially planar face 309b of the substrate 305 (as shown in Figure 3b).

The filler material 315 is an electrical conductor. The filler material 315 provides the electrical communication between the first and second outermost grooves 307a and 307b and the second substantially planar face 309b.

The cavities 314 are partially filled with a first semiconductor material 316. The first face 312a is coated with a conductor material 318 and the second face 312b is coated with a second semiconductor material 317.

The first face 312a is coated with the conductor material 318 and the second face 312b is coated with the second semiconductor material 317 using an off-axis coating technique. The cavity 314 is partially filled with the first semiconductor material using a uniform coating technique.

The off-axis directional coating requires that the coating occurs from an angle relative to each groove 320a & 320b for example, of the series of grooves 304b. The coating is sprayed into the grooves and deposited from either side of a vertical axis. The off-axis directional coating is performed in a partial vacuum. The partial vacuum ensures the coating material from the source has a sufficient mean free path, that is a direct and un-diverted path, and that the substrate is substantially free from interactions with gas or atmospheric molecules.

Spray is used herein to refer to any type of directional coating of individual elements and/or droplets, the dimensions of which are smaller than the dimensions of each groove 320a & 320b for example, of the series of grooves 304b.

The off-axis directional coating means that the coating of conductor material 318 and second semiconductor material 317 is largely restricted by viewing angle to only one side of each groove 320a & 320b for example, of the series of grooves 304b. The acceptable limits of off-axis directional coating are defined by the type of structure and/or substrate onto which the coating is deposited. The coating may be either continuous or discontinuous over a surface of the structure and/or substrate depending on its fine structure or the type of structure or substrate used.

The shape of the cavity 314 formed by and between the first and second faces 312a & 312b of the series of grooves 304b is such that the viewing angle is restricted. The restricted viewing angle is the result of the upper edges of the neighbouring groove.

The process of off-axis directional coating is further described in WO 2012/175902A1. The process of off-axis directional coating may be referred to as Glancing Angle Deposition (GLAD).

The conductor material 318 and second semiconductor material 317 are deposited on the cascaded groove structured surface 304b using off-axis directional coating, enabling the fabrication of non-contacting interdigitated conductors having defined geometries along the surface presented to the source of coating materials.

The second face 312b is often coated with a second conductor material (not shown) and then the semiconductor material 317. Both coats are applied using the off-axis coating technique. The semiconductor material 317 is then coated on top of the second conductor material (not shown). The conductor material 318 and second conductor material (not shown) are then used as connections, sometimes for input and output connections, to the first 316 and second 317 semiconductor materials deposited in the space between the conductor material 318 and second conductor material (not shown) on the structured surface, that is the surface of the substrate.

The second conductor material and the first conductor material are usually the same material, as shown in Figure 2a. The apertures 308a and 308b are filled by a uniform coating technique.

Cascaded groove structured surfaces address some of the problems associated with standard planar sandwich constructed devices, however these cascaded groove structured surfaces of the prior art are either interdigitated (parallel connected) or cascaded (series connected). The optoelectronic device 301 provides a mixture of interdigitated and cascaded groove structures. This allows the operating voltage of the optoelectronic device 301 to be designed and controlled by the number of series of grooves, for example 304b. Any number of series of grooves, for example 304b, can be produced and operated in parallel to provide the desired voltage output and series to provide the desired current output. The number of grooves affects the voltage and the number of series of grooves affects the current.

A conventional post off-axis directional coating demetallisation technique requires significant space to be set aside between a series of cascaded groove structures so that two properties can be maintained. The first property is a physical one in that there must be sufficient space to accommodate the delineation feature between the series of cascaded groove structures and also sufficient space to allow for registration tolerances of the technique chosen for the demetallisation technique, which may be, for example, a laser technique. The second property is that the space left after the post off-axis directional coating demetallisation process still needs to be capable of passing current of sufficient conductance to allow efficient use of the cascaded devices.

When a post off-axis directional coating demetallisation technique is used, the delineation feature or region between the series of cascaded grooves could be formed, for example, by laser cutting through the deposited conductor material whilst avoiding cutting through the supporting substrate or by the printing of metal etching material onto the deposited metals. Following the use of these techniques, the resulting delineation feature prevents the short circuiting of the positive output of one series of cascaded grooves with the negative output of the next series of cascaded grooves and prevents the lateral conduction from the individual cascaded grooves to the edge contacts.

The space required for the delineation feature to be introduced after the off-axis directional coating metallisation is relatively large and has no active function. Therefore, there is a reduction in active cascaded groove area since the delineation feature and the resulting charge extraction areas must be large enough to both allow the registration of the delineation feature with its associated tolerances and provide a low enough resistance pathway so that charge can be extracted without excessive internal losses. Consequently, for a solar photovoltaic cell, this region reduces the active area of the overall roll-to-roll fabricated product.

The optoelectronic device 301 increases the speed of, and decreases the cost of, manufacture of devices such as solar photovoltaic cells, with a concomitant increase in product yield due to reduced wastage during the manufacturing process.

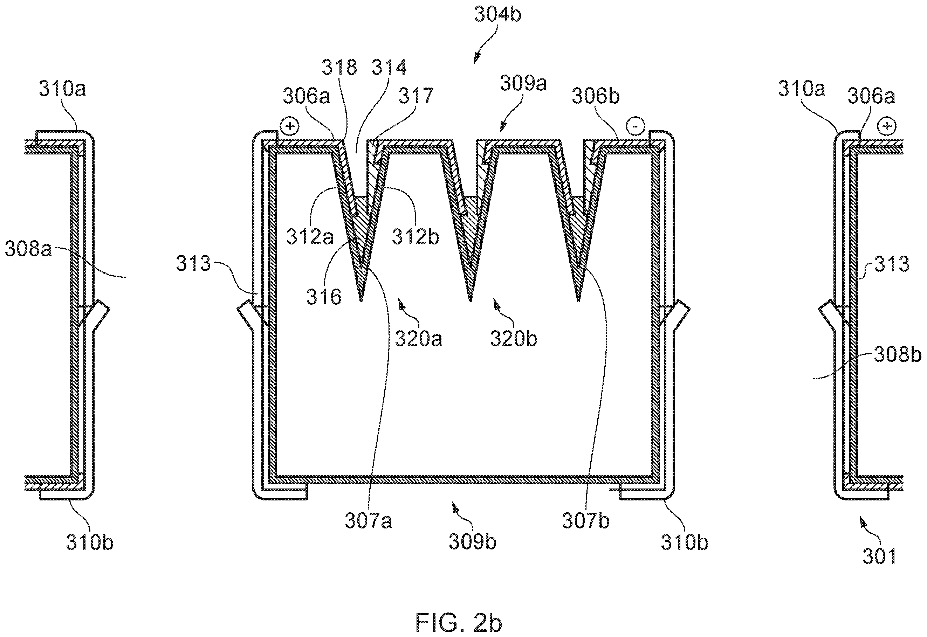

Figure 2b shows a cross-sectional view of part of the optoelectronic device 301 shown in Figures 1a and 3a along the line A-A. Each groove 320a & 320b for example, of a series of grooves 304b has a first face 312a and a second face 312b and a cavity 314 therebetween.

Figure 2b shows the sides of the apertures 308a and 308b coated with conductor materials 310a and 310b. The conductor materials 310a and 310b contact each other at 313. This contact at 313 and the extension of the conductor materials 310a and 310b out of the apertures 308a and 308b provides the electrical communication between the first and second outermost grooves 307a and 307b and the second substantially planar face 309b. The apertures 308a and 308b may or may not be filled with the filler material referred to in Figure 2a.

Figure 3a shows the second substantially planar face 309b of the substrate 305 shown in Figure 1a. The second substantially planar face 309b also comprises a first 311a and a second 311b electrical conductor. The first and second electrical conductors 311a and 311b are electrically insulated from one another by the area 305a of the second substantially planar face 309b of the substrate 305.

Figure 3a also shows the first 308a and second 308b apertures in the substrate 305, the other ends of which are shown in Figure 1a.

Figure 3b shows the second substantially planar face 309b of the substrate 305 shown in Figure 1b. The second substantially planar face 309b also comprises a first 311a and a second 311b electrical conductor. The first and second electrical conductors 311a and 311b are electrically insulated from one another by the area 305a of the second substantially planar face 309b of the substrate 305.

Figure 3b shows the first 308a and second 308b apertures in the substrate 305, the other ends of which are shown in Figure 1b. Figure 3b also shows the apertures 308c and 308d also referred to as the first and second apertures respectively.

Modifications and improvements can be incorporated herein without departing from the scope of the invention.

## Claims

1. An optoelectronic device (301) comprising:
a substrate (305) having a first and a second substantially planar face (309a, 309b);
a series of grooves (304a, 304b) in the first substantially planar face, the series of grooves including a first outermost groove (307a) and a second outermost groove (307b); and
a first and a second aperture (308a, 308b) in the substrate;
wherein the first aperture provides electrical communication between the first outermost groove and the second substantially planar face of the substrate and the second aperture provides separate electrical communication between the second outermost groove and the second substantially planar face of the substrate;
wherein the second substantially planar face of the substrate further comprises a first and a second electrical conductor (311a, 311b), the first and second electrical conductors being electrically insulated from one another; and
wherein each groove of the series of grooves has a first and a second face (312a, 312b) and a cavity (314) therebetween, the cavity at least partially filled with a first semiconductor material (316), the first face coated with a conductor material (318) and the second face coated with a second semiconductor material (317),
**characterised in that** sides of the first and second apertures are coated with one or more of the conductor material, the first semiconductor material and the second semiconductor material.

2. An optoelectronic device (301) as claimed in claim 1, wherein the first aperture (308a) passes through the first substantially planar face (309a) of the substrate (305) proximate to the first outermost groove (307a) and through the first electrical conductor (311a) on the second substantially planar face (309b) of the substrate.

3. An optoelectronic device (301) as claimed in claim 1 or claim 2, wherein the second aperture (308b) passes through the first substantially planar face (309a) of the substrate (305) proximate to the second outermost groove (307b) and through the second electrical conductor (311b) on the second substantially planar face (309b) of the substrate.

4. An optoelectronic device (301) as claimed in any preceding claim, wherein the apertures (308a, 308b) have a diameter of from 0.5 to 2000 microns.

5. An optoelectronic device (301) as claimed in any preceding claim, wherein the aperture (308a, 308b) is a hole or a slot.

6. An optoelectronic device (301) as claimed in any preceding claim, wherein the first and second apertures (308a, 308b) are at least partially filled with an electrical conductor material (310a, 310b).

7. An optoelectronic device (301) as claimed in claim 6, wherein the electrical conductor material (310a, 310b) is a conductive ink.

8. An optoelectronic device (301) as claimed in any preceding claim, wherein the series of grooves comprises a first (304a) and a second (304b) series of grooves and a channel (314) therebetween, wherein the channel transects the grooves of the first series of grooves towards an end of each groove and then passes between the first and second series of grooves before transecting the grooves of the second series of grooves towards an opposite end of each groove.

9. An optoelectronic device (301) as claimed in any preceding claim, wherein the first semiconductor material (316) is a p-type semiconductor material and the second semiconductor material (317) is an n-type semiconductor material.

10. An optoelectronic device (301) as claimed in any preceding claim, wherein the cavity (314) between the first and second faces (312a, 312b) of each groove of the first and second series of grooves (304a, 304b) is U-shaped, V-shaped or semi-spherical.

11. A method of producing an optoelectronic device (301), the method including the steps of:
providing a substrate (305) comprising a first and a second substantially planar face (309a, 309b), the second substantially planar face comprising a first and a second electrical conductor (311a, 311b), the first and second electrical conductors being electrically insulated from one another;
providing a first and a second aperture (308a, 308b) in the substrate, and a series of grooves (304a, 304b) in the first substantially planar face, the series of grooves including a first outermost groove (307a) and a second outermost groove (307b), each groove of the series of grooves having a first and a second face (312a, 312b) and a cavity (314) therebetween, the first aperture providing electrical communication between the first outermost groove and the second substantially planar face of the substrate and the second aperture providing separate electrical communication between the second outermost groove and the second substantially planar face of the substrate;
coating at least the first face with a conductor material (318) and coating the second face with a semiconductor material (316); and
at least partially filling the cavity with another semiconductor material (317)
**characterised in that** wherein the step of coating at least the first face with the conductor material and coating the second face with the semiconductor material or the step of at least partially filling the cavity with the another semiconductor material, also at least partially coats a side of or fills the first or second aperture with one or more of the conductor material, the semiconductor material and the another semiconductor material.

12. A method of producing an optoelectronic device (301) according to claim 11, the method separately including the step of creating the first and the second aperture (308a, 308b) in the substrate (305), the step being before or after the step of coating at least the first face (312a) with the conductor material (318) and coating the second face (312b) with the semiconductor material (316) or the step of at least partially filling the cavity (314) with the another semiconductor material (317).

13. A method of producing an optoelectronic device (301) according to claim 11 or 12, wherein the step of coating at least the first face (312a) of each groove of the first and second series of grooves (304a, 304b) with the conductor material (318) and coating the second face (312b) of each groove of the first and second series of grooves with the semiconductor material (316) comprises an off-axis directional coating process.

14. A method of producing an optoelectronic device according (301) to any of claims 11 to 13, wherein the step of at least partially filling the cavity (314) of each groove with the another semiconductor material (317) comprises one or more of an off-axis directional coating process, directional coating process and uniform coating process.

15. A method of producing an optoelectronic device (301) according to claim 13 or 14, wherein the off-axis directional coating process includes spraying the conductor material (318) or the semiconductor material (316, 317) at an angle relative to the plane of the substrate (305), and therefore also each of the grooves of the first and second series of grooves (304a, 304b), such that only the first or second face (312a, 312b) of each groove of the first and second series of grooves is coated.

## Patentansprüche

1. Optoelektronische Vorrichtung (301), umfassend:
ein Substrat (305), das eine erste und eine zweite im Wesentlichen ebene Fläche (309a, 309b) aufweist;
eine Reihe von Rillen (304a, 304b) in der ersten im Wesentlichen ebenen Fläche, wobei die Reihe von Rillen eine erste äußerste Rille (307a) und eine zweite äußerste Rille (307b) beinhaltet; und
eine erste und eine zweite Öffnung (308a, 308b) in dem Substrat;
wobei die erste Öffnung eine elektrische Verbindung zwischen der ersten äußersten Rille und der zweiten im Wesentlichen ebenen Fläche des Substrats bereitstellt und die zweite Öffnung eine separate elektrische Verbindung zwischen der zweiten äußersten Rille und der zweiten im Wesentlichen ebenen Fläche des Substrats bereitstellt;
wobei die zweite im Wesentlichen ebene Fläche des Substrats ferner einen ersten und einen zweiten elektrischen Leiter (311a, 311b) umfasst, wobei der erste und zweite elektrische Leiter elektrisch voneinander isoliert sind; und
wobei jede Rille der Reihe von Rillen eine erste und eine zweite Fläche (312a, 312b) und einen Hohlraum (314) dazwischen aufweist, wobei der Hohlraum zumindest teilweise mit einem ersten Halbleitermaterial (316) gefüllt ist, wobei die erste Fläche mit einem Leitermaterial (318) beschichtet ist und die zweite Fläche mit einem zweiten Halbleitermaterial (317) beschichtet ist, **dadurch gekennzeichnet, dass** die Seiten der ersten und zweiten Öffnung mit einem oder mehreren von dem Leitermaterial, dem ersten Halbleitermaterial und dem zweiten Halbleitermaterial beschichtet sind.

2. Optoelektronische Vorrichtung (301) nach Anspruch 1, wobei die erste Öffnung (308a) durch die erste im Wesentlichen ebene Fläche (309a) des Substrats (305) nahe der ersten äußersten Rille (307a) und durch den ersten elektrischen Leiter (311a) auf der zweiten im Wesentlichen ebenen Fläche (309b) des Substrats verläuft.

3. Optoelektronische Vorrichtung (301) nach Anspruch 1 oder Anspruch 2, wobei die zweite Öffnung (308b) durch die erste im Wesentlichen ebene Fläche (309a) des Substrats (305) nahe der zweiten äußersten Rille (307b) und durch den zweiten elektrischen Leiter (311b) auf der zweiten im Wesentlichen ebenen Fläche (309b) des Substrats verläuft.

4. Optoelektronische Vorrichtung (301) nach einem der vorhergehenden Ansprüche, wobei die Öffnungen (308a, 308b) einen Durchmesser von 0,5 bis 2000 µm aufweisen.

5. Optoelektronische Vorrichtung (301) nach einem der vorhergehenden Ansprüche, wobei die Öffnung (308a, 308b) ein Loch oder ein Schlitz ist.

6. Optoelektronische Vorrichtung (301) nach einem der vorhergehenden Ansprüche, wobei die erste und zweite Öffnung (308a, 308b) zumindest teilweise mit einem elektrischen Leitermaterial (310a, 310b) gefüllt sind.

7. Optoelektronische Vorrichtung (301) nach Anspruch 6, wobei das elektrische Leitermaterial (310a, 310b) eine leitfähige Tinte ist.

8. Optoelektronische Vorrichtung (301) nach einem der vorhergehenden Ansprüche, wobei die Reihe von Rillen eine erste (304a) und eine zweite (304b) Reihe von Rillen und einen Kanal (314) dazwischen umfasst, wobei der Kanal die Rillen der ersten Reihe von Rillen in Richtung eines Endes von jeder Rille durchschneidet und dann zwischen der ersten und zweiten Reihe von Rillen, vor dem Durchschneiden der Rillen der zweiten Reihe von Rillen in Richtung eines entgegengesetzten Endes von jeder Rille, verläuft.

9. Optoelektronische Vorrichtung (301) nach einem der vorhergehenden Ansprüche, wobei das erste Halbleitermaterial (316) ein p-Typ-Halbleitermaterial ist und das zweite Halbleitermaterial (317) ein n-Typ-Halbleitermaterial ist.

10. Optoelektronische Vorrichtung (301) nach einem der vorhergehenden Ansprüche, wobei der Hohlraum (314) zwischen der ersten und zweiten Fläche (312a, 312b) von jeder Rille der ersten und zweiten Reihe von Rillen (304a, 304b) U-förmig, V-förmig oder halbkugelförmig ist.

11. Verfahren zum Herstellen einer optoelektronischen Vorrichtung (301), wobei das Verfahren folgende Schritte beinhaltet:
Bereitstellen eines Substrats (305), das eine erste und eine zweite im Wesentlichen ebene Fläche (309a, 309b) umfasst, wobei die zweite im Wesentlichen ebene Fläche einen ersten und einen zweiten elektrischen Leiter (311a, 311b) umfasst, wobei der erste und zweite elektrische Leiter elektrisch voneinander isoliert sind;
Bereitstellen einer ersten und einer zweiten Öffnung (308a, 308b) in dem Substrat und einer Reihe von Rillen (304a, 304b) in der ersten im Wesentlichen ebenen Fläche, wobei die Reihe von Rillen eine erste äußerste Rille (307a) und eine zweite äußerste Rille (307b) beinhaltet, wobei jede Rille der Reihe von Rillen eine erste und eine zweite Fläche (312a, 312b) und einen Hohlraum (314) dazwischen aufweist, wobei die erste Öffnung eine elektrische Verbindung zwischen der ersten äußersten Rille und der zweiten im Wesentlichen ebenen Fläche des Substrats bereitstellt und die zweite Öffnung eine separate elektrische Verbindung zwischen der zweiten äußersten Rille und der zweiten im Wesentlichen ebenen Fläche des Substrats bereitstellt;
Beschichten von zumindest der ersten Fläche mit einem Leitermaterial (318) und Beschichten der zweiten Fläche mit einem Halbleitermaterial (316); und
zumindest teilweises Befüllen des Hohlraums mit einem anderen Halbleitermaterial (317), **dadurch gekennzeichnet, dass** der Schritt des Beschichtens von zumindest der ersten Fläche mit dem Leitermaterial und des Beschichtens der zweiten Fläche mit dem Halbleitermaterial oder der Schritt des zumindest teilweisen Befüllens des Hohlraums mit dem anderen Halbleitermaterial auch zumindest teilweise mit einem oder mehreren von dem Leitermaterial, dem Halbleitermaterial und dem anderen Halbleitermaterial eine Seite von der ersten oder zweiten Öffnung beschichtet oder die erste oder zweite Öffnung befüllt.

12. Verfahren zum Herstellen einer optoelektronischen Vorrichtung (301) nach Anspruch 11, wobei das Verfahren separat den Schritt des Erzeugens der ersten und der zweiten Öffnung (308a, 308b) in dem Substrat (305) beinhaltet, wobei der Schritt vor oder nach dem Schritt des Beschichtens von zumindest der ersten Fläche (312a) mit dem Leitermaterial (318) und des Beschichtens der zweiten Fläche (312b) mit dem Halbleitermaterial (316) oder dem Schritt des zumindest teilweisen Befüllens des Hohlraums (314) mit dem anderen Halbleitermaterial (317) ist.

13. Verfahren zum Herstellen einer optoelektronischen Vorrichtung (301) nach Anspruch 11 oder 12, wobei der Schritt des Beschichtens von zumindest der ersten Fläche (312a) von jeder Rille der ersten und zweiten Reihe von Rillen (304a, 304b) mit dem Leitermaterial (318) und des Beschichtens der zweiten Fläche (312b) von jeder Rille der ersten und zweiten Reihe von Rillen mit dem Halbleitermaterial (316) einen achsenversetzten gerichteten Beschichtungsprozess umfasst.

14. Verfahren zum Herstellen einer optoelektronischen Vorrichtung nach (301) einem der Ansprüche 11 bis 13, wobei der Schritt des zumindest teilweisen Befüllens des Hohlraums (314) von jeder Rille mit dem anderen Halbleitermaterial (317) einen oder mehrere von einem achsenversetzten gerichteten Beschichtungsprozess, gerichteten Beschichtungsprozess und gleichmäßigen Beschichtungsprozess umfasst.

15. Verfahren zum Herstellen einer optoelektronischen Vorrichtung (301) nach Anspruch 13 oder 14, wobei der achsenversetzte gerichtete Beschichtungsprozess das Aufsprühen des Leitermaterials (318) oder des Halbleitermaterials (316, 317) in einem Winkel relativ zur Ebene des Substrats (305) und daher auch jede der Rillen der ersten und zweiten Reihe von Rillen (304a, 304b) beinhaltet, derart, dass nur die erste oder zweite Fläche (312a, 312b) von jeder Rille der ersten und zweiten Reihe von Rillen beschichtet ist.

## Revendications

1. Dispositif optoélectronique (301) comprenant :
un substrat (305) possédant une première et une seconde face (309a, 309b) sensiblement planes ;
une série de rainures (304a, 304b) dans la première face sensiblement plane, la série de rainures comprenant une première rainure la plus externe (307a) et une seconde rainure la plus externe (307b) ; et
une première et une seconde ouverture (308a, 308b) dans le substrat ; ladite première ouverture fournissant une communication électrique entre la première rainure la plus externe et la seconde face sensiblement plane du substrat et ladite seconde ouverture fournissant une communication électrique séparée entre la seconde rainure la plus externe et la seconde face sensiblement plane du substrat ;
ladite seconde face sensiblement plane du substrat comprenant en outre un premier et un second conducteur électrique (311a, 311b), les premier et second conducteurs électriques étant isolés électriquement l'un de l'autre ; et
chaque rainure de la série de rainures comportant une première et une seconde face (312a, 312b) et une cavité (314) entre celles-ci, la cavité étant au moins partiellement remplie d'un premier matériau semi-conducteur (316), la première face étant revêtue d'un matériau conducteur (318) et la seconde face étant revêtue d'un second matériau semi-conducteur (317),
**caractérisé en ce que** les côtés des première et seconde ouvertures sont revêtus de l'un ou de plusieurs parmi le matériau conducteur, le premier matériau semi-conducteur et le second matériau semi-conducteur.

2. Dispositif optoélectronique (301) selon la revendication 1, ladite première ouverture (308a) passant à travers la première face sensiblement plane (309a) du substrat (305) à proximité de la première rainure la plus externe (307a) et à travers le premier conducteur électrique (311a) sur la seconde face sensiblement plane (309b) du substrat.

3. Dispositif optoélectronique (301) selon la revendication 1 ou 2, ladite seconde ouverture (308b) passant à travers la première face sensiblement plane (309a) du substrat (305) à proximité de la seconde rainure la plus externe (307b) et à travers le second conducteur électrique (311b) sur la seconde face sensiblement plane (309b) du substrat.

4. Dispositif optoélectronique (301) selon l'une quelconque des revendications précédentes, lesdites ouvertures (308a, 308b) possédant un diamètre allant de 0,5 à 2000 micromètres.

5. Dispositif optoélectronique (301) selon l'une quelconque des revendications précédentes, ladite ouverture (308a, 308b) étant un trou ou une fente.

6. Dispositif optoélectronique (301) selon l'une quelconque des revendications précédentes, lesdites première et seconde ouvertures (308a, 308b) étant au moins partiellement remplies d'un matériau électroconducteur (310a, 310b).

7. Dispositif optoélectronique (301) selon la revendication 6, ledit matériau électroconducteur (310a, 310b) étant une encre conductrice.

8. Dispositif optoélectronique (301) selon l'une quelconque des revendications précédentes, ladite série de rainures comprenant une première (304a) et une seconde (304b) série de rainures et un canal (314) entre celles-ci, ledit canal coupant les rainures de la première série de rainures vers une extrémité de chaque rainure et passant ensuite entre les première et seconde séries de rainures avant de couper les rainures de la seconde série de rainures vers une extrémité opposée de chaque rainure.

9. Dispositif optoélectronique (301) selon l'une quelconque des revendications précédentes, ledit premier matériau semi-conducteur (316) étant un matériau semi-conducteur de type p et ledit second matériau semi-conducteur (317) étant un matériau semi-conducteur de type n.

10. Dispositif optoélectronique (301) selon l'une quelconque des revendications précédentes, ladite cavité (314) entre les première et seconde faces (312a, 312b) de chaque rainure de la première et de la seconde série de rainures (304a, 304b) étant en forme de U, en forme de V ou semi-sphérique.

11. Procédé de production d'un dispositif optoélectronique (301), le procédé comprenant les étapes de :
fourniture d'un substrat (305) comprenant une première et une seconde face (309a, 309b) sensiblement planes, la seconde face sensiblement plane comprenant un premier et un second conducteur électrique (311a, 311b), les premier et second conducteurs électriques étant isolés électriquement l'un de l'autre ;
aménagement d'une première et d'une seconde ouverture (308a, 308b) dans le substrat et d'une série de rainures (304a, 304b) dans la première face sensiblement plane, la série de rainures comprenant une première rainure la plus externe (307a) et une seconde rainure la plus externe (307b), chaque rainure de la série de rainures possédant une première et une seconde face (312a, 312b) et une cavité (314) entre celles-ci, la première ouverture fournissant une communication électrique entre la première rainure la plus externe et la seconde face sensiblement plane du substrat et la seconde ouverture fournissant une communication électrique séparée entre la seconde rainure la plus externe et la seconde face sensiblement plane du substrat ;
revêtement d'au moins la première face d'un matériau conducteur (318) et revêtement de la seconde face d'un matériau semi-conducteur (316) ; et
remplissage, au moins partiellement, de la cavité avec un autre matériau semi-conducteur (317) **caractérisé en ce que** l'étape de revêtement d'au moins la première face avec le matériau conducteur et de revêtement de la seconde face avec le matériau semi-conducteur ou l'étape de remplissage, au moins partiellement, de la cavité avec l'autre matériau semi-conducteur, recouvrant également, au moins partiellement, un côté de la première ou la seconde ouverture ou remplissant la première ou la seconde ouverture avec un ou plusieurs parmi le matériau conducteur, le matériau semi-conducteur et l'autre matériau semi-conducteur.

12. Procédé de production d'un dispositif optoélectronique (301) selon la revendication 11, le procédé comprenant séparément l'étape de création de la première et de la seconde ouverture (308a, 308b) dans le substrat (305), l'étape étant avant ou après l'étape de revêtement d'au moins la première face (312a) avec le matériau conducteur (318) et de revêtement de la seconde face (312b) avec le matériau semi-conducteur (316) ou l'étape de remplissage, au moins partiellement, de la cavité (314) avec l'autre matériau semi-conducteur (317).

13. Procédé de production d'un dispositif optoélectronique (301) selon la revendication 11 ou 12, ladite étape de revêtement d'au moins la première face (312a) de chaque rainure des première et seconde séries de rainures (304a, 304b) avec le matériau conducteur (318) et de revêtement de la seconde face (312b) de chaque rainure des première et seconde séries de rainures avec le matériau semi-conducteur (316) comprenant un processus de revêtement directionnel hors axe.

14. Procédé de production d'un dispositif optoélectronique selon (301) l'une quelconque des revendications 11 à 13, ladite étape de remplissage au moins partielle de la cavité (314) de chaque rainure avec l'autre matériau semi-conducteur (317) comprenant l'un ou plusieurs parmi un processus de revêtement directionnel hors axe, un processus de revêtement directionnel et un processus de revêtement uniforme.

15. Procédé de production d'un dispositif optoélectronique (301) selon la revendication 13 ou 14, ledit processus de revêtement directionnel hors axe comprenant la pulvérisation du matériau conducteur (318) ou du matériau semi-conducteur (316, 317) selon un angle par rapport au plan du substrat (305), et donc également de chacune des rainures des première et seconde séries de rainures (304a, 304b), de sorte qu'uniquement la première ou la seconde face (312a, 312b) de chaque rainure des première et seconde séries de rainures soit revêtue.
